Europäisches Patentamt

European Patent Office

Office européen des brevets

(19)

(11) EP 1 443 668 A1

(12) EUROPEAN PATENT APPLICATION

(43) Date of publication:
04.08.2004 Bulletin 2004/32

(51) Int Cl.$^7$: H04B 1/707, H03G 3/30,
H03M 1/18

(21) Application number: 03388069.1

(22) Date of filing: 29.10.2003

(84) Designated Contracting States:
AT BE BG CH CY CZ DE DK EE ES FI FR GB GR
HU IE IT LI LU MC NL PT RO SE SI SK TR
Designated Extension States:
AL LT LV MK

(30) Priority: 30.01.2003 DK 200300120

(71) Applicant: Telefonaktiebolaget LM Ericsson
(publ)
164 83 Stockholm (SE)

(72) Inventors:
• Jonsson, Elias
211 29 Malmö (SE)
• Bengtsson, Magnus
214 21 Malmö (SE)

(74) Representative: Boesen, Johnny Peder et al
Zacco Denmark A/S
Hans Bekkevolds Allé 7
2900 Hellerup (DK)

(54) **Truncation and level adjustment of RAKE output symbols**

(57) A method of receiving radio signals in a receiver for a digital wireless communications system comprises the steps of level adjusting a received radio signal by an automatic gain control (12); and despreading the signal in a RAKE unit (14) having a number of fingers. The despread data symbols are truncated to symbols represented by a smaller number of bits than that of the despread data symbols by selecting the least significant bits of the despread data symbols. The truncated data symbols are saturated; and the despread data symbols are level adjusted in dependence of said despread data symbols, so that overflow for the truncated data symbols is prevented. In this way the number of bits used to represent the despread data symbols that are output from the fingers of the RAKE can be reduced in such a way that the loss of soft information is minimized.

Fig. 7

EP 1 443 668 A1

## Description

### Technical Field of the Invention

The invention relates to a method of receiving radio signals in a receiver for a digital wireless communications system, the method comprising the steps of level adjusting a received radio signal by an automatic gain control; and despreading the level adjusted signal in a RAKE unit having a number of fingers, thus providing a number of despread data symbols, each despread data symbol being represented by a first number of bits. The invention also relates to a receiver for receiving radio signals in a digital wireless communications system.

### Description of Related Art

In wireless communications systems the physical channel between a transmitter and a receiver is typically formed by a radio link. As an example, the transmitter could be a base station, and the receiver could be a mobile station, or vice versa. In most cases the transmit antenna is not narrowly focused towards the receiver. This means that the transmitted signals may propagate over multiple paths. In addition to a possible direct path from the transmitter to the receiver, many other propagation paths caused by reflections from objects in the surroundings exist. Thus, the receiver may receive multiple instances of the same signal at different times, i.e. with different delays, because different portions of the signal are reflected from various objects, such as buildings, moving vehicles or landscape details.

These different portions of the signal are a cause of interference in the receiver. Depending on the time resolution of the transmission system and the instantaneous phase relationship, portions with similar propagation distances combine at the receiver and form a distinct multipath component. The effect of the combining depends on the instantaneous relationship of the carrier wavelength and distance differences, and it may thus for a given multipath component be either enhancing or destructive. In case of destructive interference, the combining leads to significant decrease of the magnitude, or fading, of the path gain for that path.

This interference is treated differently in different transmission systems. Many transmission systems try to reduce the effect of multipath propagation and fading by using receivers that combine the data symbol energy from all multipath components. In Code Division Multiple Access (CDMA) and Wideband Code Division Multiple Access (WCDMA) systems the energy of the different received portions of the signal may be utilized in the receiver by using a so-called RAKE receiver.

In these systems spreading and despreading is used. Data are transmitted from the transmitter side using a spread spectrum modulation technique wherein the data are scattered across a wide range of frequencies. Each channel is assigned a unique spreading code that is used to spread the data across the frequency range. The spreading code is a pseudo-random noise (PN) code and is composed of e.g. a binary sequence of 1's and 0's, called "chips", that are distributed in a pseudo-random manner and have noise-like properties. The number of chips used to spread one data bit, i.e. chips/bit, may vary, and it depends, at least in part, on the data rate of the channel and the chip rate of the system.

In the receiver the received signal is despread and demodulated with the same spreading code using the same chip rate to recover the transmitted data. Furthermore, the timing of the demodulation must be synchronized, i. e. the despreading code must be applied to the received signal at the correct instant in time, which can be difficult due to the multipath effects mentioned above. The performance of a CDMA receiver is improved by utilizing the signal energy carried by many multipath components. As mentioned, this is achieved by using a RAKE receiver, where each multipath component is assigned a despreader whose reference copy of the spreading code is delayed equally to the path delay of the corresponding multipath component. Thus, in each finger of the RAKE receiver the received chip sequence is despread (correlated) with the correspondingly delayed spreading code. The despread output symbols from each RAKE finger are then coherently combined to produce a symbol estimate.

Typically, in such a receiver system the radio signal is first down-converted to base band by a radio interface. Then the analog down-converted signal is scaled by an automatic gain control (AGC), before being quantized by an analog-to-digital (A/D) converter. It is noted that the analog signal is complex and thus consists of an *I* part and a *Q* part. Once the received signal has been quantized it is despread in the RAKE. As mentioned, a radio signal can have travelled through different paths before arriving at the receiver, which causes the signal to be received at different time delays. Given the time of arrival of each path, the received quantized signal is despread in the RAKE for each path by multiplying the quantized signal, sampled at chip rate, with its corresponding channelization code and scrambling code and sum over the length of the channelization code. The radio channel estimates are then calculated and their conjugates are multiplied with the despread data symbols. The products are then summed over the number of paths. Finally, the bit stream is decoded.

The scaling of the signal from the AGC may be performed so that the average power of the sum of the *I* and *Q* parts is kept as close as possible to a given reference value. The measured power, i.e. the feedback to the AGC, can be taken before or after the A/D converter. Usually, some kind of control algorithm is involved in finding the optimal scale factor for the AGC. It is assumed that such an algorithm is given.

One example of such a receiver system is known from WO 00/69086, which shows a WCDMA receiver with a RAKE circuit. Here the signal level is first adjusted with a relatively coarse gain control at the down-converted and quantized complex chip stream. A refined gain control is then subsequently performed by means of AGC circuits at the individual despread data symbols that are output from the fingers of the RAKE. However, this two-step level adjustment will often be too slow to follow rapid changes in the received signal.

To minimize the size and complexity of such receivers, it would be advantageous to be able to reduce the number of bits used to represent the despread data symbols that are output from the fingers of the RAKE, because due to the considerable number of possible fingers a high buffer capacity must be reserved for this purpose. However, the loss of soft important information, e.g. phase information, normally associated with such a reduction will typically not be acceptable, because of the resulting deteriorated receiver performance.

Therefore, it is an object of the invention to provide a method of receiving radio signals in which the number of bits used to represent the despread data symbols that are output from the fingers of the RAKE can be reduced in such a way that the loss of soft information is minimized.

Summary

According to the invention the object is achieved in that the method further comprises the step of truncating the despread data symbols provided from the RAKE unit to obtain truncated data symbols represented by a second number of bits, said second number being smaller than said first number, wherein the second number of bits are selected as the least significant bits of the first number of bits representing a despread data symbol; saturating the truncated data symbols to obtain saturated data symbols by replacing a truncated data symbol with the highest value that can be represented by the second number of bits, if the value of the despread data symbol from which that truncated data symbol was obtained is larger than said highest value, and replacing a truncated data symbol with the lowest value that can be represented by the second number of bits, if the value of the despread data symbol from which that truncated data symbol was obtained is less than said lowest value; and level adjusting the despread data symbols provided from the RAKE unit in dependence of said despread data symbols, so that overflow for the truncated data symbols is prevented.

The use of truncation and saturation reduces the number of bits needed to represent the data symbols from the fingers of the RAKE, but since the level adjustment is performed before the RAKE unit and the output levels from the individual fingers may differ considerably from each other, there would, with the use of truncation and saturation alone, still be a risk of overflow for one or more of the data symbols resulting in loss of information in the truncation and saturation process. This problem is solved when the truncation and saturation is combined with a further level adjustment, so that the level of the symbols provided from the RAKE is adjusted in dependence of the level of the saturated data symbols to prevent overflow.

It is noted that although the buffer capacity needed for storing and processing the despread data symbols provided from the RAKE unit could also be reduced by truncating and saturating the quantized signal before it is fed to the RAKE unit, or simply by using an A/D converter with a lower number of output bits, such a solution would be less attractive, because if the signal is then reduced to a level, where the signals from the stronger paths do not saturate, information from the weaker paths might be lost. The signal from very weak paths might even be cancelled so that the corresponding fingers of the RAKE unit would only produce noise, the resulting receiver performance being further deteriorated. Therefore, in order to ensure that the information of the weaker paths is also utilized, it is preferred to maintain a high number of bits to represent the input signals to the RAKE unit.

In an expedient embodiment the step of level adjusting the despread data symbols provided from the RAKE unit comprises the step of measuring the level of the despread data symbols. Alternatively, the step of level adjusting the despread data symbols provided from the RAKE unit comprises the step of measuring the level of the saturated data symbols.

The level adjusting of the despread data symbols may be performed by adjusting a reference value of said automatic gain control. Alternatively, the level adjusting of the despread data symbols may be performed by adjusting the level of each despread data symbol individually in dependence of that despread data symbol.

Expediently, the level adjusting may be based on the largest of an inphase component and a quadrature component of said despread data symbols.

When the level adjusting is based on data symbols averaged over time, it is ensured that rapid noise fluctuations do not change the adjustment level.

Expediently, the level adjusting is performed by using a Proportional-Integral control algorithm.

A simple embodiment is obtained when the level adjusting is performed by selecting one of two different adjustment levels.

As mentioned, the invention also relates to a receiver for receiving radio signals in a digital wireless communications system, the receiver having means for level adjusting a received radio signal by an automatic gain control; and despreading the level adjusted signal in a RAKE unit having a number of fingers, thus providing a number of despread data symbols, each despread data symbol being represented by a first number of bits.

When the receiver further comprises means for truncating the despread data symbols provided from the RAKE unit to obtain truncated data symbols represented by a second number of bits, said second number being smaller than said first number, wherein the second number of bits are selected as the least significant bits of the first number of bits representing a despread data symbol; saturating the truncated data symbols to obtain saturated data symbols by replacing a truncated data symbol with the highest value that can be represented by the second number of bits, if the value of the despread data symbol from which that truncated data symbol was obtained is larger than said highest value, and replacing a truncated data symbol with the lowest value that can be represented by the second number of bits, if the value of the despread data symbol from which that truncated data symbol was obtained is less than said lowest value; and level adjusting the despread data symbols provided from the RAKE unit in dependence of said despread data symbols, so that overflow for the truncated data symbols is prevented, a receiver is achieved in which the number of bits used to represent the despread data symbols that are output from the fingers of the RAKE can be reduced in such a way that the loss of soft information is minimized.

In an expedient embodiment the receiver is adapted to adjust the level of the despread data symbols provided from the RAKE unit by means of measuring the level of the despread data symbols. Alternatively, the receiver is adapted to adjust the level of the despread data symbols provided from the RAKE unit by means of measuring the level of the saturated data symbols.

The receiver may be adapted to adjust the level of the despread data symbols by adjusting a reference value of said automatic gain control. Alternatively, the receiver may be adapted to adjust the level of the despread data symbols by adjusting the level of each despread data symbol individually in dependence of that despread data symbol.

Expediently, the receiver may be adapted to base said level adjusting on the largest of an inphase component and a quadrature component of said despread data symbols.

When the receiver is adapted to base said level adjusting on data symbols averaged over time, it is ensured that rapid noise fluctuations do not change the adjustment level.

Expediently, the receiver is adapted to perform said level adjusting by using a Proportional-Integral control algorithm.

A simple embodiment is obtained when the receiver is adapted to perform said level adjusting by selecting one of two different adjustment levels.

Expediently, the receiver may be a WCDMA receiver.

The invention also relates to a computer program and a computer readable medium with program code means for performing the method described above.

Brief Description of the Drawings

The invention will now be described more fully below with reference to the drawings, in which

figure 1 shows an example of multiple paths between a base station and a mobile station,

figure 2 shows a power delay profile for the paths illustrated in figure 1,

figure 3 shows a known receiver structure,

figure 4 shows the receiver of figure 3 modified with a truncation and saturation unit,

figure 5 illustrates a situation with saturation of one of the I and Q components of a truncated data symbol,

figure 6 illustrates a situation with saturation of both the I and Q components of a truncated data symbol,

figure 7 shows a receiver structure in which the AGC unit is adjusted in dependence of the truncated and saturated data symbols,

figure 8 shows a flow chart of a part of the structure of figure 7,

figure 9 shows a receiver structure in which the AGC unit is adjusted in dependence of the despread data symbols, and

figure 10 shows a receiver structure in which the despread data symbols are adjusted in dependence of the truncated and saturated data symbols.

Detailed Description of Embodiments

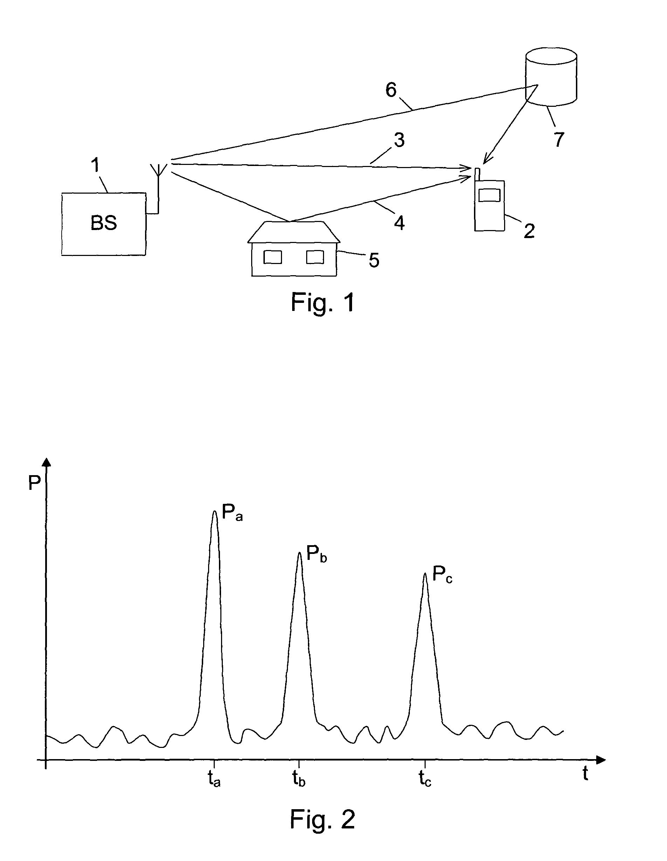

Figure 1 shows a situation in which a base station 1 and a mobile station 2 of a wireless communications system communicate with each other. As an example, a signal transmitted from the base station 1 is received by the mobile station 2. However, the transmitted signal travels along multiple paths from the base station to the mobile station. In this case there is a direct and unobstructed propagation path 3, but in addition to this direct path, reflections from objects in the surroundings cause a number of indirect paths to exist. Two such paths are shown in the figure. One indirect path 4 is reflected from a house 5, while another path 6 is caused by reflection from another building 7.

Since the part of a signal transmitted via one of the indirect paths 4 and 6 has to travel a longer distance to arrive at the mobile station 2, compared to the part of the signal travelling via the direct path 3, multiple instances of the same signal will be received by the mobile station 2 at different times, i.e. with different delays.

Thus, if a pilot signal is transmitted from the base station 1, the power P received at the mobile station 2 as a function of the time t may look as illustrated in figure 2, which shows an example of a power delay profile. The power delay profile shows all signals received at the mobile station, including noise and interference signals. However, only the peaks in the power delay profile correspond to the multipath components of the transmitted signal. Together these peaks form the impulse response of the channel. In figure 2 the peak $P_a$ received at the time $t_a$ corresponds to the direct path 3 in figure 1, while the peaks $P_b$ and $P_c$ received at the times $t_b$ and $t_c$, respectively, correspond to the indirect paths 4 and 6 in figure 1. Thus, as an example, it is seen that the delay of the path 6 (corresponding to the peak $P_c$) is larger than the delay of the path 3 (corresponding to the peak $P_a$).

The mobile station 2 and the base station 1 may be adapted for use in e.g. a Code Division Multiple Access (CDMA) system or a Wideband Code Division Multiple Access (WCDMA) system, and in that case the mobile station 2 may use a RAKE receiver, which is capable of identifying and tracking the various multipath signals for a given channel. In this way the energy or power of several multipath components can be utilized in the receiver. As mentioned above, this may be achieved by using a RAKE receiver, where each multipath component is assigned a despreader whose reference copy of the spreading code is delayed equally to the path delay of the corresponding multipath component. The outputs of the despreaders, i.e. the fingers of the RAKE receiver, are then coherently combined to produce a symbol estimate.

Although reference is here made to a RAKE receiver in a mobile station, it should be noted that the algorithms described below may be used at any CDMA receiver, i.e. in a mobile station or a base station, and the transmission may be uplink or downlink.

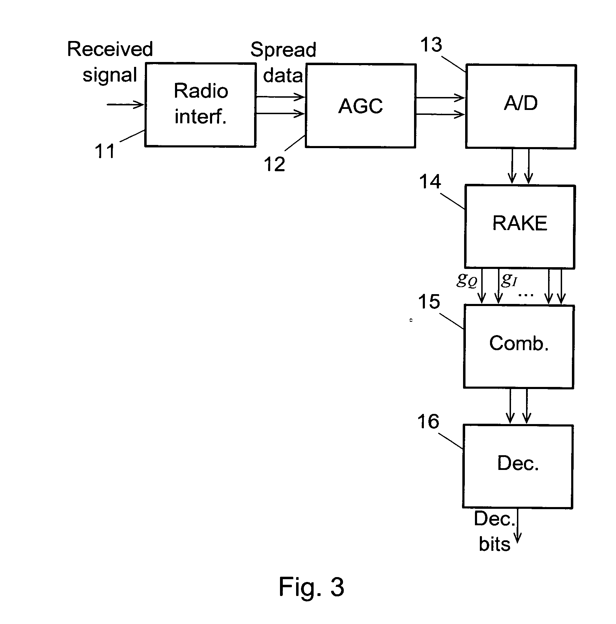

Figure 3 illustrates an example of a typical receiver structure for a RAKE receiver. The radio signal is first down-converted to base band by a radio interface 11. Then the analog down-converted signal is scaled by an automatic gain control (AGC) unit 12, before being quantized by an analog to digital (A/D) converter 13. It is noted that the analog signal is complex and thus consists of an *I* part and a *Q* part.

Once the received signal has been quantized it is despread in a RAKE unit 14. As mentioned, a radio signal can have travelled through different paths before arriving at the receiver, which causes the signal to be received at different time delays. In the RAKE unit 14, each reported delay estimate (path) is assigned a RAKE finger, and the received quantized signal is despread for each path by multiplying the quantized signal, sampled at chip rate, with its corresponding channelization code and scrambling code and sum over the length of the channelization code. Each RAKE finger presents a complex despread data symbol with the values $g_I$ and $g_Q$, each represented by $N_g$ bits.

In the combining unit 15, the radio channel estimates are then calculated and their conjugates are multiplied by the despread data symbols. The products for each RAKE finger are then summed over the number of paths. Finally, the bit stream is decoded in the decoder 16.

The scaling of the signal in the AGC unit 12 may be performed so that the average power of the sum of the *I* and *Q* parts is kept as close as possible to a given reference value. The measured power, i.e. the feedback to the AGC, can be taken before or after the A/D converter 13. The optimal scale factor for the AGC is found by means of a control algorithm, of which several algorithms are well known.

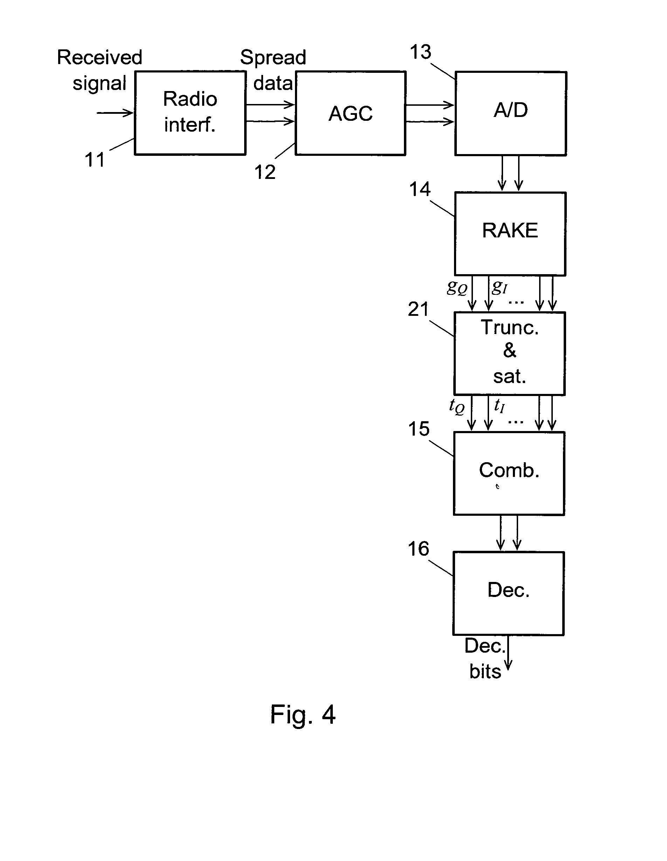

Due to the considerable number of possible fingers, a high buffer capacity is needed to store and process the despread data symbols that are output from the fingers of the RAKE unit 14. The high buffer capacity requires a larger silicon area and thus a larger size and a higher complexity of the receiver. Therefore, it would be advantageous to be able to reduce the number of bits used to represent each despread data symbol. This can be obtained by truncating and saturating the despread data symbols, as illustrated in figure 4, in which a truncation and saturation unit 21 is inserted between the RAKE unit 14 and the combining unit 15. The truncated and saturated values $t_I$ and $t_Q$ are computed from the values $g_I$ and $g_Q$ by extracting the $N_t$ least significant bits, if this still equals $g_I$ or $g_Q$. Otherwise, there is overflow, and $t_I$ or $t_Q$ is set to the maximum or minimum value that can be represented by $N_t$ bits, depending on the sign of $g_I$ or $g_Q$. The function of the truncation and saturation unit 21 can be defined as

$$y = sat(x) = \begin{cases} M_y, & x \geq M_y, \\ x, & m_y < x < M_y, \\ m_y, & x \leq m_y, \end{cases}$$

where $x$ is a number represented by an integer number of bits $N_x$. $M_x$ and $m_x$ are defined to be the maximum and minimum achievable number using the bit representation of $x$. Correspondingly, $y$ can be represented with $N_y$ integer bits, where $N_y$ is less than $N_x$, and $M_y$ and $m_y$ are defined to be the maximum and minimum achievable number using the bit representation of $y$.

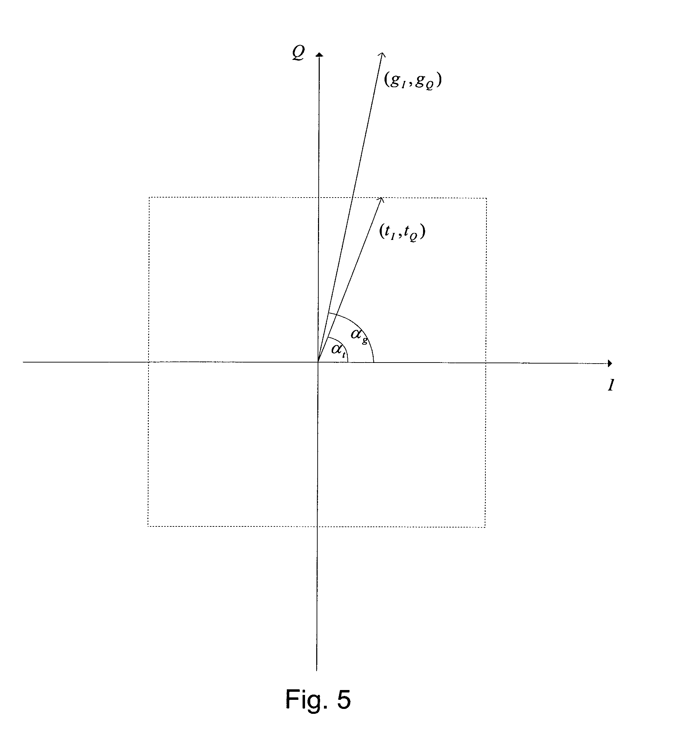

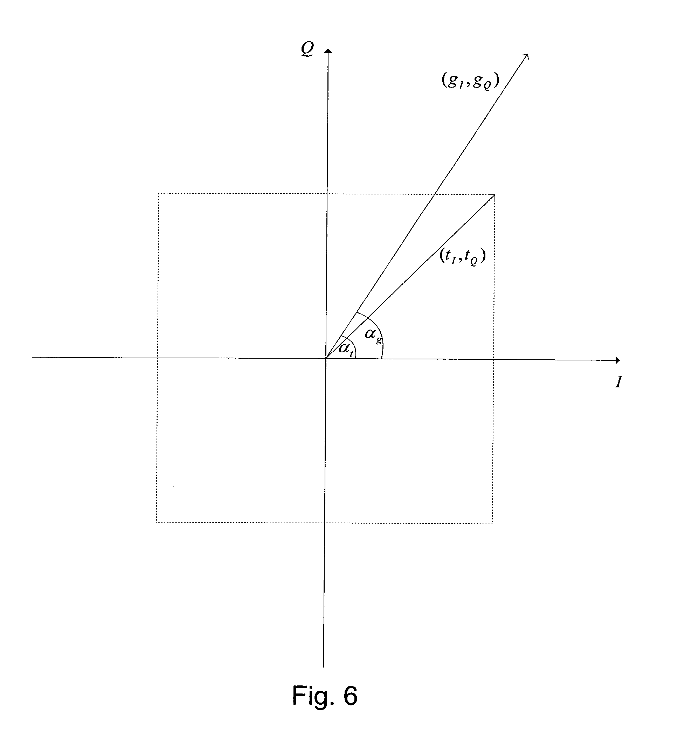

By saturating the signals $t_I$ or $t_Q$ in the truncation and saturation unit 21, the problem of overflow is partly solved. However, there is a risk of loosing valuable phase information between $g_I$ or $g_Q$. Figure 5 illustrates a situation where only one of $t_I$ or $t_Q$, in this case $t_Q$, saturates. A dotted box shows the maximum values of $t_I$ or $t_Q$. In the figure the coordinate $(g_I, g_Q)$ fall outside the box and will thus be truncated. The result of the truncation and saturation is shown as the coordinate $(t_I, t_Q)$. It is immediately seen that the truncation and saturation introduces a phase error. The phase of the complex data symbol is changed from $\alpha_g$ to $\alpha_t$. If both $t_I$ and $t_Q$ saturates, even more phase information is loosed, since only four different phases are possible, which is illustrated in Figure 6. Again the dotted box shows the maximum values of $t_I$ or $t_Q$. In the figure both $g_I$ and $g_Q$ fall outside the box and will thus be truncated. The result of the truncation and saturation is shown as the coordinate $(t_I, t_Q)$, which will be located at one of the corners of the box. It is immediately seen that the truncation and saturation introduces a phase error. In both cases, valuable soft information is loosed, which results in a deteriorated performance.

Therefore, the truncation and saturation is combined with an adjustment of the level of the RAKE outputs, i. e. the despread data symbols, with an adaptive factor depending on the level of the individual despread data symbols outputs. This can be done in a number of different ways, which will be described below.

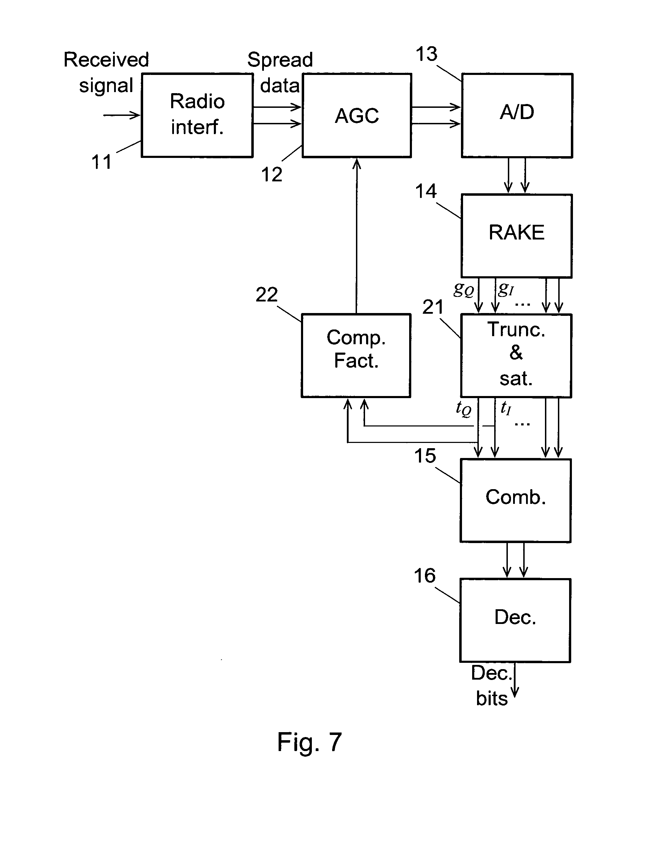

One solution is illustrated in figure 7. Here the reference value for the AGC unit 12 is adjusted in dependence of the truncated and saturated values $t_I$ and $t_Q$. The reference value or factor is calculated in the factor computing unit 22, which will be described in further detail below.

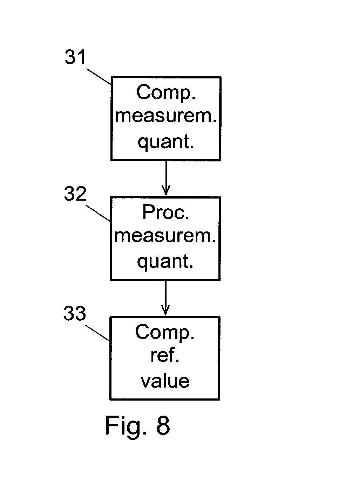

A flow chart of the factor computing unit 22 is shown in figure 8. In step 31 data are taken from the truncation and saturation unit 21, and measurement quantities are computed for all involved physical channels or paths. The values $t_I^{(CH)}$ and $t_Q^{(CH)}$ for each physical path or channel $CH$ are sampled according to a predetermined pattern. A given number of physical channels can be studied in parallel. In order to check if either the $I$ or $Q$ part has saturated, the measurement quantity

$$\Omega^{(CH)} = \max(\left|t_I^{(CH)}\right|, \left|t_Q^{(CH)}\right|)$$

is computed for each physical channel, where $|x|$ means the absolute value of $x$.

In step 32 the computed measurement quantities are processed. An expectation value of $\Omega^{(CH)}$ is computed. This can, for example, be done by filtering

$$\Omega_{n+1}^{(CH)} = (1-\alpha)\Omega_n^{(CH)} + \alpha\Omega^{(CH)}.$$

Here, the time constant for $\alpha$, i.e. the time it takes to compute the corresponding moving average, should be much larger than the time constant for the AGC loop. Furthermore, the time constant for $\alpha$ should be large enough to filter over a number of fading peaks and dips.

In step 33 a new reference value for the AGC circuit 12 is computed. If $\Omega_{ref}^{(CH)}$ is the reference value for $\Omega_n^{(CH)}$, a new reference power value $P_{ref}^{(CH)}$ for the AGC unit is computed using a Proportional-Integral controller (PI controller), in which an error signal is integrated and used for eliminating steady state or offset errors, i.e. the following is calculated

$$e_n^{(CH)} = \Omega_{ref}^{(CH)} - \Omega_n^{(CH)},$$

$$I_{n+1}^{(CH)} = I_n^{(CH)} + \frac{1}{T_i} e_n^{(CH)}.$$

Here $I_n^{(CH)}$ is stored from the last activation of the block, and $T_i$ is an integration constant. The new reference power for the AGC for channel $CH$ is taken as

$$P_{ref}^{(CH)} = K(e_n^{(CH)} + I_n^{(CH)})$$

for some constant $K$.

As shown in figure 7 there is only one AGC, and thus the final reference value is set as

$$P_{ref} = \min_{CH}(P_{ref}^{(CH)}).$$

It is noted that more general controllers can be used in this algorithm, but for ease of presentation the simple PI controller has been chosen.

The algorithm of step 33 mentioned above may also be simplified as will now be described. It is assumed that two reference power levels, $P_1$ and $P_2$, are used. The following steps are then performed:

$$\textbf{if } \Omega_n^{(CH)} > M_{t_I}(1 - \gamma_1)$$

$$P_{ref}^{(CH)} = P_1$$

$$\textbf{elseif } \Omega_n^{(CH)} < M_{t_I}(1 - \gamma_2)$$

$$P_{ref}^{(CH)} = P_2$$

$$\textbf{end}$$

Here, $M_{t_I}$ denotes the maximum value represented by $t_1$, which is the same for $t_Q$. This algorithm toggles between two states. Here, $\gamma_1 < \gamma_2$ and $P_1 < P_2$. Having $\gamma_1 < \gamma_2$ introduces a viscosity to the system, which prevents the system from toggling between the two reference values $P_1$ and $P_2$ from one activation of the block to the other. In this algorithm, it is straight forward to generalize to include more than two power reference value levels.

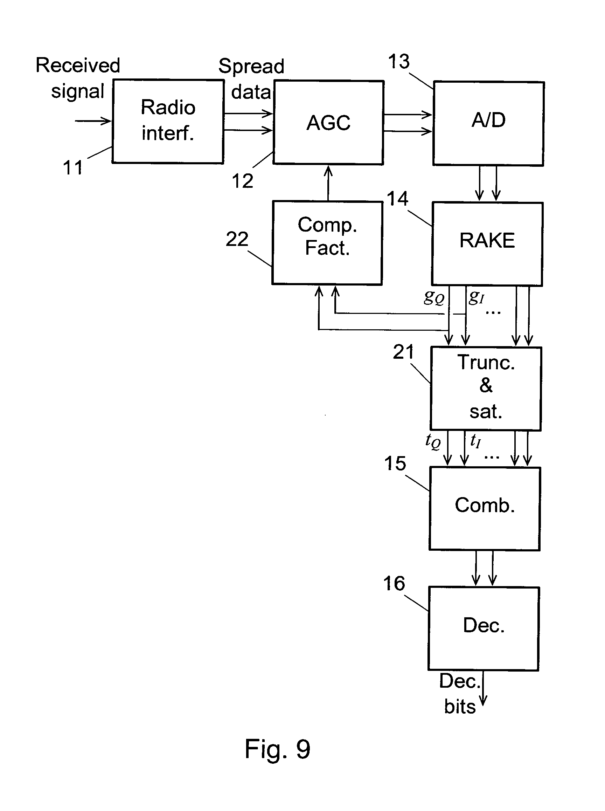

Instead of using the values $t_I^{(CH)}$ and $t_Q^{(CH)}$ for each physical path or channel $CH$ in step 31 as described above and shown in figure 7, the values $g_I^{(CH)}$ and $g_Q^{(CH)}$ may be used, because they also contain the necessary information. This is illustrated in figure 9.

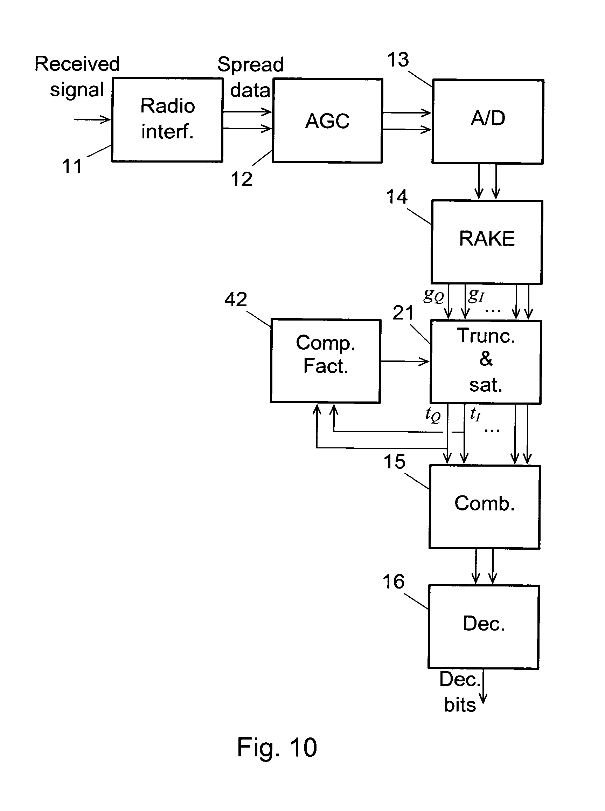

In an alternative embodiment, the individual despread data symbol with the values $g_I$ and $g_Q$ may be scaled with an adaptive factor before truncation and saturation in the unit 21, instead of adjusting the AGC control as described above. This is illustrated in figure 10, which corresponds to figure 7, but instead of the factor computing unit 22 connected to the AGC unit 12 this embodiment has a factor computing unit 42 connected to the truncation and saturation unit 21. The flow chart of figure 8 is also valid for the factor computing unit 42, but the algorithm used in step 33 is different. An example of an algorithm that can be used here is described below.

If $\Omega_{ref}^{(CH)}$ is the reference value for $\Omega_n^{(CH)}$, the new reference scale value for the truncation and saturation unit 21, $S_{ref}^{(CH)}$, can be computed using a PI controller, i.e.

$$e_n^{(CH)} = \Omega_{ref}^{(CH)} - \Omega_n^{(CH)},$$

$$I_{n+1}^{(CH)} = I_n^{(CH)} + \frac{1}{T_i} e_n^{(CH)}$$

Here $I_n^{(CH)}$ is stored from the last activation of the truncation and saturation unit 21, and $T_i$ is an integration constant. The new reference scale value for channel $CH$ can then be taken as

$$S_{ref}^{(CH)} = K(e_n^{(CH)} + I_n^{(CH)})$$

for some constant $K$.

The truncation and saturation in unit 21 is then done as follows,

$$t_I^{(CH)} = sat(floor(g_I^{(CH)} \cdot S_{ref}^{(CH)})),$$

$$t_Q^{(CH)} = sat(floor(g_Q^{(CH)} \cdot S_{ref}^{(CH)})),$$

where the integer part of the number $x$ is represented as $floor(x)$.

Again in this algorithm more general controllers can be used, but for ease of presentation the simple PI controller is chosen.

Also here the algorithm can be used in a simplified version. If it is assumed that there are two reference scale levels, $S_1$ and $S_2$, the following steps may then be performed

$$\textbf{if } \Omega_n^{(CH)} > M_{t_I}(1 - \gamma_1)$$

$$S_{ref}^{(CH)} = S_1$$

$$\textbf{elseif } \Omega_n^{(CH)} < M_{t_I}(1 - \gamma_2)$$

$$S_{ref}^{(CH)} = S_2$$

$$\textbf{end}$$

Here, $M_{t_I}$ denotes the maximum value represented by $t_I$, which is the same for $t_Q$. This algorithm toggles between two states. Here, $\gamma_1 < \gamma_2$ and $P_1 < P_2$. Having $\gamma_1 < \gamma_2$ introduces a viscosity to the system, which prevents the system from toggling between the two reference values $P_1$ and $P_2$ from one activation of the unit to the other.

The truncation and saturation in unit 21 is then done as follows,

$$t_I^{(CH)} = sat(floor(g_I^{(CH)} \cdot S_{ref}^{(CH)})),$$

$$t_Q^{(CH)} = sat(floor(g_Q^{(CH)} \cdot S_{ref}^{(CH)})).$$

It is straight forward to generalize this algorithm to include more than two power reference value levels.

Also here the values $g_I^{(CH)}$ and $g_Q^{(CH)}$ may be used for each physical path or channel CH in step 31 instead of the values $t_I^{(CH)}$ and $t_Q^{(CH)}$ as described above, because they also contain the necessary information.

It is noted that in the circuits described above, all the gain estimation is performed by the AGC unit 12 on the chip stream, i.e. before the signals are despread in the RAKE unit 14. The level adjustment performed by the units 22 or 42 can be considered as a safety check to prevent any overflow at symbol level, i.e. after the despreading, by performing a complementary slow gain adjustment based on the symbol stream.

Although a preferred embodiment of the present invention has been described and shown, the invention is not restricted to it, but may also be embodied in other ways within the scope of the subject-matter defined in the following claims.

**Claims**

1. A method of receiving radio signals in a receiver (2) for a digital wireless communications system, the method comprising the steps of:

   - level adjusting a received radio signal by an automatic gain control (12); and
   - despreading the level adjusted signal in a RAKE unit (14) having a number of fingers, thus providing a number of despread data symbols, each despread data symbol being represented by a first number of bits,

   **characterized in that** the method further comprises the step of

   - truncating the despread data symbols provided from the RAKE unit (14) to obtain truncated data symbols represented by a second number of bits, said second number being smaller than said first number, wherein the second number of bits are selected as the least significant bits of the first number of bits representing a despread data symbol;
   - saturating the truncated data symbols to obtain saturated data symbols by replacing a truncated data symbol with the highest value that can be represented by the second number of bits, if the value of the despread data symbol from which that truncated data symbol was obtained is larger than said highest value, and replacing a truncated data symbol with the lowest value that can be represented by the second number of bits, if the value of the despread data symbol from which that truncated data symbol was obtained is less than said lowest value; and
   - level adjusting the despread data symbols provided from the RAKE unit (14) in dependence of said despread data symbols, so that overflow for the truncated data symbols is prevented.

2. A method according to claim 1, **characterized in that** said step of level adjusting the despread data symbols provided from the RAKE unit (14) comprises the step of measuring the level of the despread data symbols.

3. A method according to claim 1, **characterized in that** said step of level adjusting the despread data symbols provided from the RAKE unit (14) comprises the step of measuring the level of the saturated data symbols.

4. A method according to any one of claims 1 to 3, **characterized in that** said level adjusting of the despread data symbols is performed by adjusting a reference value of said automatic gain control (12).

5. A method according to any one of claims 1 to 3, **characterized in that** said level adjusting of the despread data symbols is performed by adjusting the level of each despread data symbol individually in dependence of that despread data symbol.

6. A method according to any one of claims 1 to 5, **characterized in that** said level adjusting is based on the largest of an inphase component and a quadrature component of said despread data symbols.

7. A method according to any one of claims 1 to 6, **characterized in that** said level adjusting is based on data symbols averaged over time.

8. A method according to any one of claims 1 to 7, **characterized in that** said level adjusting is performed by using a Proportional-Integral control algorithm.

9. A method according to any one of claims 1 to 8, **characterized in that** said level adjusting is performed by selecting one of two different adjustment levels.

10. A receiver (2) for receiving radio signals in a digital wireless communications system, the receiver having means for:

   • level adjusting a received radio signal by an automatic gain control (12); and
   • despreading the level adjusted signal in a RAKE unit (14) having a number of fingers, thus providing a number of despread data symbols, each despread data symbol being represented by a first number of bits,

   **characterized in that** the receiver further comprises means for

   • truncating the despread data symbols provided from the RAKE unit (14) to obtain truncated data symbols represented by a second number of bits, said second number being smaller than said first number, wherein the second number of bits are selected as the least significant bits of the first number of bits representing a despread data symbol;
   • saturating the truncated data symbols to obtain saturated data symbols by replacing a truncated data symbol with the highest value that can be represented by the second number of bits, if the value of the despread data symbol from which that truncated data symbol was obtained is larger than said highest value, and replacing a truncated data symbol with the lowest value that can be represented by the second number of bits, if the value of the despread data symbol from which that truncated data symbol was obtained is less than said lowest value; and
   • level adjusting the despread data symbols provided from the RAKE unit (14) in dependence of said despread data symbols, so that overflow for the truncated data symbols is prevented.

11. A receiver according to claim 10, **characterized in that** it is adapted to adjust the level of the despread data symbols provided from the RAKE unit (14) by means of measuring the level of the despread data symbols.

12. A receiver according to claim 10, **characterized in that** it is adapted to adjust the level of the despread data symbols provided from the RAKE unit (14) by means of measuring the level of the saturated data symbols.

13. A receiver according to any one of claims 10 to 12, **characterized in that** it is adapted to adjust the level of the despread data symbols by adjusting a reference value of said automatic gain control (12).

14. A receiver according to any one of claims 10 to 12, **characterized in that** it is adapted to adjust the level of the despread data symbols by adjusting the level of each despread data symbol individually in dependence of that despread data symbol.

15. A receiver according to any one of claims 10 to 14, **characterized in that** it is adapted to base said level adjusting on the largest of an inphase component and a quadrature component of said despread data symbols.

16. A receiver according to any one of claims 10 to 15, **characterized in that** it is adapted to base said level adjusting on data symbols averaged over time.

17. A receiver according to any one of claims 8 to 13, **characterized in that** it is adapted to perform said level adjusting by using a Proportional-Integral control algorithm.

18. A receiver according to any one of claims 10 to 17, **characterized in that** it is adapted to perform said level adjusting by selecting one of two different adjustment levels.

19. A receiver according to any one of claims 10 to 18, **characterized in that** the receiver is a WCDMA receiver.

20. A computer program comprising program code means for performing the steps of any one of the claims 1 to 9 when said computer program is run on a computer.

21. A computer readable medium having stored thereon program code means for performing the method of any one of the claims 1 to 9 when said program code means is run on a computer.

Fig. 1

Fig. 2

Fig. 3

Fig. 4

Fig. 5

Fig. 6

Received
signal

Spread
data

13

Radio
interf.

AGC

A/D

11

12

14

RAKE

$g_Q$   $g_I$   ...

22

21

Comp.
Fact.

Trunc.
&
sat.

$t_Q$   $t_I$   ...

15

Comb.

16

Dec.

Dec.
bits

Fig. 7

31

Comp.
measurem.
quant.

32

Proc.
measurem.
quant.

33

Comp.
ref.
value

Fig. 8

Fig. 9

Fig. 10

| European Patent Office | EUROPEAN SEARCH REPORT | Application Number EP 03 38 8069 |
|---|---|---|

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| A | WO 00/69086 A (BORGHS ERIC ;VANHOOF JAN (BE); LUGIL NICO (BE); MERTENS CARL (BE);) 16 November 2000 (2000-11-16) * paragraphs [0103]-[0109],[0113]-[0116],[0128]-[0155]; claims 1,8,16-28; figures 8,9 * --- | 1-21 | H04B1/707 H03G3/30 H03M1/18 |
| A | DE 199 18 385 A (SIEMENS AG) 2 November 2000 (2000-11-02) * column 2, line 25 - column 3, line 11 * * column 3, line 26 - column 4, line 35; figure 1 * ----- | 1-21 | |
| | | | TECHNICAL FIELDS SEARCHED (Int.Cl.7) H04B H03G H03M |

The present search report has been drawn up for all claims

| Place of search THE HAGUE | Date of completion of the search 7 May 2004 | Examiner Nilsson, M |
|---|---|---|

EPO FORM 1503 03.82 (P04C01)

## ANNEX TO THE EUROPEAN SEARCH REPORT
## ON EUROPEAN PATENT APPLICATION NO.

EP 03 38 8069

This annex lists the patent family members relating to the patent documents cited in the above-mentioned European search report.
The members are as contained in the European Patent Office EDP file on
The European Patent Office is in no way liable for these particulars which are merely given for the purpose of information.

07-05-2004

| Patent document cited in search report | | Publication date | Patent family member(s) | | Publication date |
|---|---|---|---|---|---|
| WO 0069086 | A | 16-11-2000 | AU | 4529200 A | 21-11-2000 |
| | | | WO | 0069086 A1 | 16-11-2000 |
| | | | EP | 1175734 A1 | 30-01-2002 |
| | | | JP | 2002544706 T | 24-12-2002 |
| | | | US | 2002196754 A1 | 26-12-2002 |
| DE 19918385 | A | 02-11-2000 | DE | 19918385 A1 | 02-11-2000 |
| | | | CN | 1355958 T | 26-06-2002 |
| | | | WO | 0065721 A1 | 02-11-2000 |
| | | | EP | 1183782 A1 | 06-03-2002 |
| | | | US | 6690312 B1 | 10-02-2004 |